# EUROPEAN PATENT APPLICATION

(11) **EP 4 848 918 A1**
(43) Date of publication of application: **02.12.2026**
(21) Application number: 26181027.9
(22) Date of filing: 26.05.2026
(51) Int. Cl.: H05K 7/20

(54) **TWO-PHASE COLD PLATE WITH BOILING ENHANCEMENT SURFACE**

(30) Priority: 27.05.2025 US 202563812493 P; 21.05.2026 US 202619684303
(71) Applicant: Vertiv Corporation, Westerville, OH 43082 (US)
(72) Inventor: TIPTON, Russell C., Westerville, 43082 (US); SCHRADER, Timothy James, Westerville, 43082 (US)
(74) Representative: Kilburn & Strode LLP

(57) **Abstract**

A two-phase cold plate includes a housing having a base plate, a top plate, and sidewalls delimiting a fluid channel, a plurality of structural posts disposed in the fluid channel and extending between the base plate and the top plate, a fluid inlet fluidly coupled to the fluid channel, and a fluid outlet fluidly coupled to the fluid channel. In embodiments, the base plate has a boiling enhancement surface including a plurality of thermally conductive structures extending from the base plate into the fluid channel for providing increased surface area for heat transfer within the fluid channel. In embodiments, the thermally conductive structures emulate biomimetic structures such as a forest of trees.

## Description

### CROSS REFERENCE TO RELATED APPLICATION

This application claims the benefit of priority of U.S. Application Number 63/812,493 filed May 27, 2025.

### TECHNICAL FIELD

The present disclosure relates generally to datacenter cooling systems, and more particularly, to a two-phase cold plate including a boiling enhancement surface.

### BACKGROUND

Datacenters and other high-performance computing (HPC) environments generate significant heat that must be removed to maintain performance and avoid overheating of electronic components such as CPUs, GPUs, DPUs, and related circuitry. As power densities continue to increase, conventional air cooling solutions that rely on forced airflow are often unable to provide sufficient heat removal without excessive fan power, noise, and space requirements. As a result, liquid-based cooling systems have become more widely adopted, including single-phase systems and two-phase systems that take advantage of phase change to improve heat transfer.

Two-phase cold plates are commonly used in these liquid cooling systems due to their ability to provide efficient heat removal while maintaining relatively stable device temperatures. In a typical pumped two-phase cooling cycle, a liquid working fluid, such as a refrigerant, is pumped through a series of rack and row manifolds, hoses, flow regulators, and quick disconnects before entering a cold plate that operates as an evaporator. Heat transferred from the electronic component into the cold plate causes the working fluid to boil, thereby absorbing heat through evaporation. The resulting vapor is then routed to a condenser where it is condensed back into liquid form, rejecting the absorbed heat to an external heat sink. The liquid refrigerant is then recirculated and the cycle repeats. In practice, the cold plate is mounted in direct thermal contact with the heat-generating component to provide localized, high-efficiency cooling.

While existing two-phase cold plates offer substantial benefits, performance can still be limited by boiling instability, uneven heat distribution, and localized dry-out at high heat flux conditions. These issues can reduce overall efficiency and limit the ability of the cold plate to support next-generation computing hardware. Accordingly, there remains a need for improved two-phase cold plate designs that enhance boiling performance and heat transfer, including cold plates having boiling enhancement surfaces with thermally conductive structures configured to promote nucleate boiling and improve overall thermal efficiency.

### SUMMARY

According to one aspect, disclosed herein is a two-phase cold plate including a housing including a base plate, a top plate, and sidewalls delimiting a fluid channel, a plurality of structural posts disposed in the fluid channel and extending between the base plate and the top plate, a fluid inlet fluidly coupled to the fluid channel, and a fluid outlet fluidly coupled to the fluid channel. In embodiments, the base plate has a boiling enhancement surface including a plurality of thermally conductive structures extending from the base plate into the fluid channel for providing increased surface area for heat transfer within the fluid channel.

In some embodiments, the plurality of thermally conductive structures are biomimetic structures that emulate a forest of trees.

In some embodiments, the plurality of thermally conductive structures are separate structures positioned in spaced apart relation.

In some embodiments, the base plate and the plurality of thermally conductive structures are integrally formed.

In some embodiments, the base plate and the plurality of thermally conductive structures are copper.

In some embodiments, the fluid inlet is disposed through one of the sidewalls or through the top plate, and the fluid outlet is disposed through one of the sidewalls or through the top plate.

In some embodiments, the base plate and the top plate are parallel, and the plurality of structural posts are orthogonal to the base plate and the top plate.

In some embodiments, the thickness of the base plate is between 0.5 mm and 2.0 mm.

In some embodiments, a height of the fluid channel is between 3.0 mm and 10.0 mm, and a height of each of the plurality of thermally conductive structures is no more than 5.0 mm.

In some embodiments, the thickness of the base plate is less than the thickness of each of the top plate and the sidewalls.

According to another aspect, disclosed herein is a cooling system including a two-phase cold plate configured to be positioned in thermal contact with electronic equipment, and a vaporizable refrigerant configured to be pumped through the cooling system. In embodiments, the two-phase cold plate includes a housing having a base plate, a top plate, and sidewalls delimiting a fluid channel, a plurality of structural posts disposed in the fluid channel and extending between the base plate and the top plate, a fluid inlet fluidly coupled to the fluid channel, and a fluid outlet fluidly coupled to the fluid channel. In embodiments, the base plate has a boiling enhancement surface including a plurality of thermally conductive structures extending from the base plate into the fluid channel for providing increased surface area for heat transfer within the fluid channel. In embodiments, the thermally conductive structures emulate biomimetic structures such as a forest of trees.

According to a further aspect, disclosed herein is a two-phase cold plate including a housing defining a fluid channel and including a base plate, a top plate, and sidewalls extending between the base plate and the top plate, a fluid inlet configured to deliver a working fluid into the fluid channel, a fluid outlet configured to discharge the working fluid from the fluid channel, a plurality of structural posts disposed within the fluid channel and extending between the base plate and the top plate configured to structurally support the housing and maintain a spacing between the base plate and the top plate, and a boiling enhancement surface formed on the base plate including a plurality of thermally conductive structures extending from the base plate into the fluid channel, wherein the plurality of thermally conductive structures are configured to increase a heat transfer surface area within the fluid channel and to promote nucleate boiling of the working fluid within the fluid channel, wherein the plurality of thermally conductive structures are configured to emulate a forest of trees and are arranged in spaced-apart relation to facilitate fluid flow between adjacent thermally conductive structures, and wherein the base plate is configured to be thermally coupled to an electronic heat source such that heat is conducted into the working fluid within the fluid channel to cause evaporation of the working fluid.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated, and some features may be omitted or may be represented schematically in the interest of clarity. Like reference numerals in the drawings may represent and refer to the same or similar element, feature, or function. In the drawings:
FIG. 1 illustrates a schematic perspective view of a two-phase cold plate, in accordance with an example embodiment of the present disclosure;
FIG. 2 illustrates a schematic cross-sectional view of the two-phase cold plate including a sidewall fluid inlet and top plate fluid outlet, in accordance with an example embodiment of the present disclosure;
FIG. 3 illustrates a schematic cross-sectional view of the two-phase cold plate including a top plate fluid inlet and top plate fluid outlet, in accordance with an example embodiment of the present disclosure;
FIG. 4 illustrates a schematic cross-sectional view of the two-phase cold plate including a fluid inlet and fluid outlet disposed in opposing sidewalls, in accordance with an example embodiment of the present disclosure;
FIG. 5 illustrates a schematic cross-sectional view of the two-phase cold plate showing the disposition of a top plate fluid outlet and plurality of structural posts, in accordance with an example embodiment of the present disclosure;
FIG. 6 illustrates a schematic perspective view of a bottom plate including integrally formed thermally conductive structures, in accordance with an example embodiment of the present disclosure; and
FIG. 7 is a microscopic image of prior art biomimetic structures suitable for use as thermally conductive structures in the two-phase cold plate according to the present disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

The present disclosure provides embodiments of a two-phase cold plate including thermally conductive surface structures for facilitating heat dissipation to prevent excessive temperature of electronic equipment in thermal contact with the two-phase cold plate. In embodiments, the thermally conductive structures may be biomimetic structures that emulate elements in nature, for instance a tree structure having a trunk and branches providing a large surface area for high thermal conductivity and low resistance to the flow of liquid and vapor through the two-phase cold plate. In embodiments, the thermally conductive structures may be integrally formed with a base plate, for instance built as an internal boiling enhancement surface by an additive manufacturing process. In embodiments, the two-phase cold plate may include an array of structural posts extending between top and bottom plates to minimize bottom plate thickness and bottom plate deflection under pressure.

In embodiments, the two-phase cold plate may be directly attachable to high heat density electronic equipment such as a CPU, GPU, DPU, etc., for instance within a datacenter environment. In use, heat removed via the two-phase cold plate may be dissipated through a condenser that may be collocated with or positioned remote from the electronic equipment. In embodiments, fluid lines may be used between the condenser and the two-phase cold plate to move pumped working fluid (e.g., refrigerant) under pressure through a pumped two-phase refrigerant cycle. In use, two-phase fluid pumped into the cold plate undergoes a phase transformation from liquid to vapor whereby heat is absorbed and the two-phase fluid is subsequently transferred to a condenser whereby vapor condenses to liquid thereby releasing heat into the environment or into a heat recapture system for use elsewhere in the datacenter. In embodiments, the two-phase cold plate may be part of a larger cooling system including an intelligent controller and sensors for monitoring temperature, flow, etc. In embodiments, one or more of the two-phase cold plates can be implemented as part of a liquid cooling system in a datacenter.

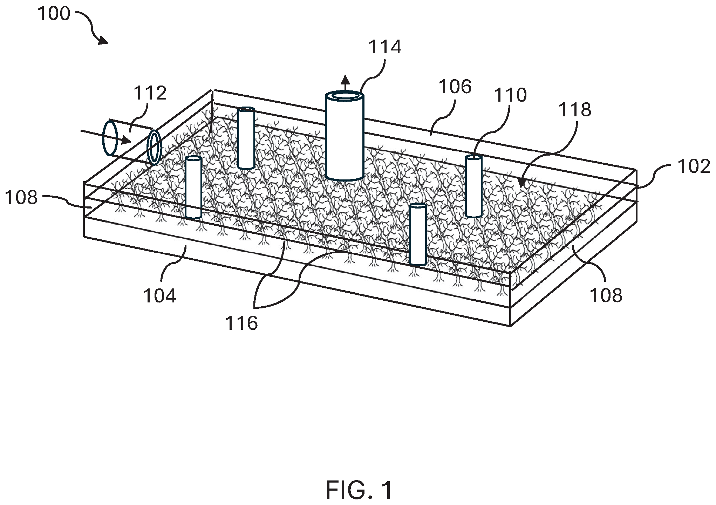

FIG. 1 illustrates a two-phase cold plate 100 according to an embodiment of the present disclosure. In embodiments, the two-phase cold plate 100 generally includes a housing 102 including a bottom plate 104, a top plate 106, and a plurality of sidewalls 108. In embodiments, one or more of the bottom plate 104, top plate 106, and sidewalls 108 may be integrally formed. In the rectangular embodiment shown, the plurality of sidewalls 108 may include first and second pairs of opposing parallel sidewalls. It is understood that the shape of the housing 102 shown is not limited to rectangular but may be customized to substantially correspond to the electronic equipment to be cooled.

In embodiments, the housing components delimit an interior space forming a fluid channel 118 configured to receive a two-phase working fluid (e.g., refrigerant). In embodiments, the two-phase cold plate 100 further includes a plurality of structural posts 110 extending between the bottom plate 104 and the top plate 106. In embodiments in which the bottom plate 104 and the top plate 106 are parallel, the structural posts 110 may be oriented orthogonal to each of the bottom plate 104 and the top plate 106. In embodiments, the structural posts 110 may be integrally formed with one or more of the bottom plate 104 and the top plate 106 or may be separately formed and thereafter attached.

In use, the structural posts 110 interconnect the bottom and top plates 104, 106, provide structural integrity to the bottom plate 104, minimize bottom plate 104 deflection under pressure, and reduce the occurrence of 'hot spots' caused by interruption of the thermal enhancement features discussed in detail below. Advantageously, the structural posts 110 allow for a thinner bottom plate 104 as compared to traditional two-phase cold plates, and as compared to the top plate 106 and sidewalls 108, thereby optimizing the thermal conductance path from the electronic equipment to the thermally conductive structures discussed in detail below. For example, the bottom plate thickness may range from 0.3 mm to 3.0 mm, more particularly from 0.5 mm to 2.0 mm, and most preferably from 0.75 mm to 1.25 mm. In embodiments, the bottom plate may be copper.

In embodiments, the two-phase cold plate 100 defines an inlet side including a fluid inlet 112, and an outlet side including a fluid outlet 114. Each of the fluid inlet 112 and the fluid outlet 114 are fluidly coupled to the fluid channel 118. In embodiments, the fluid inlet 112 is configured to be coupled to an inlet line (not shown) for supplying the fluid channel 118 with two-phase fluid such as from a liquid pump or manifold, and the fluid outlet is configured to be coupled to an outlet line (not shown) for exiting the two-phase fluid from the fluid channel 118 to a condenser. In embodiments, the inlet and outlet lines may be metal tubing. In embodiments, the inlet line may be coupled to a flow regulator enabling the two-phase fluid to enter the fluid channel 118 at a constant flow rate regardless of CPU, GPU, DPU load and facilitate phase transformation as the two-phase fluid absorbs heat.

In embodiments, the two-phase cold plate 100 further includes a plurality of thermally conductive structures 116 in thermal contact with the base plate 104. In embodiments, the thermally conductive structures 116 are disposed on the surface of the base plate 104 opposite the surface in contact with the electronic equipment. In this disposition, the thermally conductive structures 116 extend from the base plate 104 toward the top plate 106 to be positioned in the fluid channel 118. In use, the two-phase fluid flows through the thermally conductive structures 116 thereby absorbing heat transferred from the thermally conductive structures 116 from the base plate 104. In other words, an optimized thermal conductance path is formed from the base plate 104 to the thermally conductive structures 116 to the two-phase fluid.

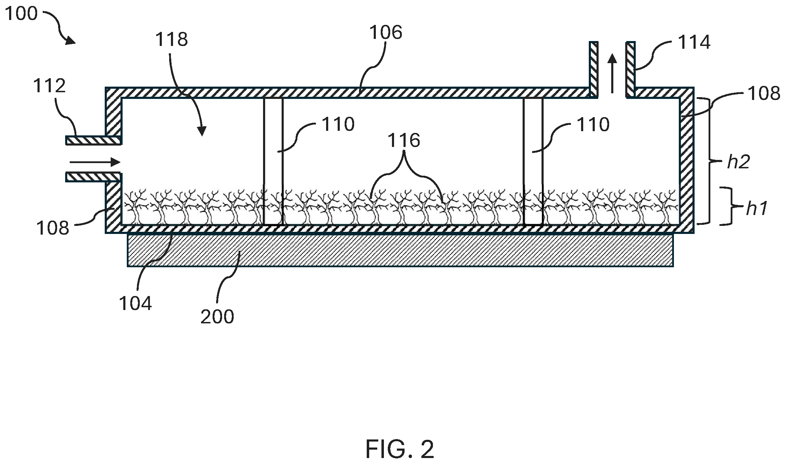

FIG. 2 illustrates a configuration of the two-phase cold plate 100 including the fluid inlet 112 disposed through a sidewall 108 on the inlet side of the two-phase cold plate 100, and the fluid outlet 114 disposed through the top plate 106 spaced apart from the fluid inlet 112. In this configuration, two-phase fluid flowing from the fluid inlet 112 to the fluid outlet 114 along the fluid channel 118 passes through the upstanding thermally conductive structures 116 extending 'upward' from the base plate 104. As shown, the bottom surface of the base plate 104 is in thermal contact with electronic equipment 200 such that heat from the electronic equipment 200 is transferred to the two-phase fluid from the base plate 104 to the thermally conductive structures 116 along an optimized thermal conductive pathway.

In embodiments, the height *h1* of the thermally conductive structures 116 is no more than 5.0 mm, more preferably no more than 3.0 mm, and most preferably no more than 2.0 mm. In embodiments, the height *h2* of the fluid channel 118 may be at least 2.0 mm, and is no more than 10.0 mm, more preferably no more than 8.0 mm, and most preferably no more than 6.0 mm. In embodiments, the 'top' of the thermally conductive structures 116 is positioned below the 'bottom' of the fluid inlet 112 to minimize resistance as the two-phase fluid enters the fluid channel 118. Likewise, the scale of the structural posts 110 is optimized to minimize flow resistance while providing the structural support necessary to minimize bottom plate 104 deflection.

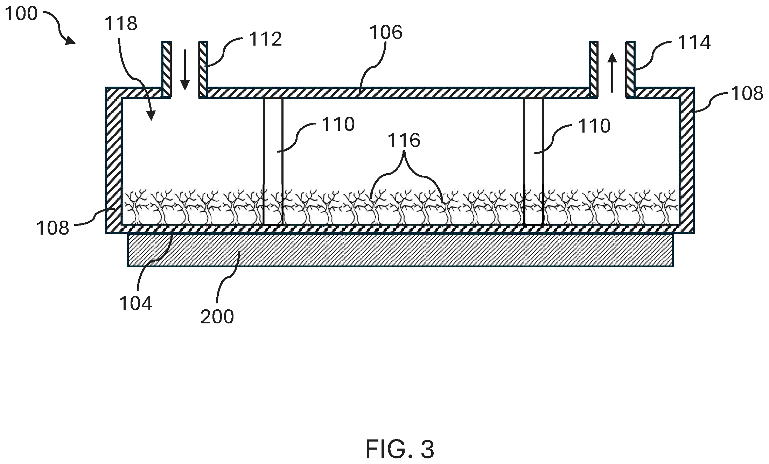

FIG. 3 illustrates a configuration of the two-phase cold plate 100 including the fluid inlet 112 disposed through the top plate 106 on an inlet side of the top plate 106, and the fluid outlet 114 also disposed through the top plate 106 on an outlet side of the top plate 106 positioned spaced apart from the fluid inlet 112. In this configuration, two-phase fluid flowing from the fluid inlet 112 to the fluid outlet 114 along the fluid channel 118 passes through the upstanding thermally conductive structures 116 extending 'upward' from the base plate 104. In this configuration, the disposition of the fluid inlet 112 may allow for 'taller' thermally conductive structures 116 as compared to the disposition of the fluid inlet 112 in the two-phase cold plate configuration shown in FIG. 2.

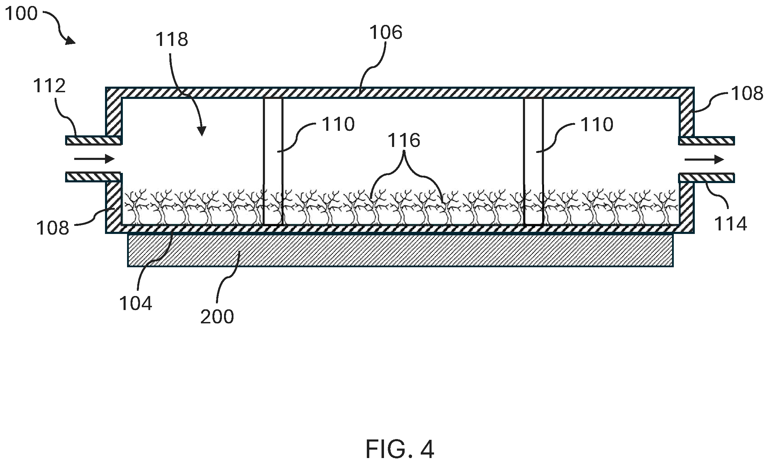

FIG. 4 illustrates yet another configuration of the two-phase cold plate 100 including the fluid inlet 112 disposed through one sidewall 108 on an inlet side of the two-phase cold plate 100, and the fluid outlet 114 disposed through an opposing sidewall 108 on an outlet side of the two-phase cold plate 100. In this configuration, two-phase fluid flowing from the fluid inlet 112 to the fluid outlet 114 along the fluid channel 118 passes through the upstanding thermally conductive structures 116 extending 'upward' from the base plate 104.

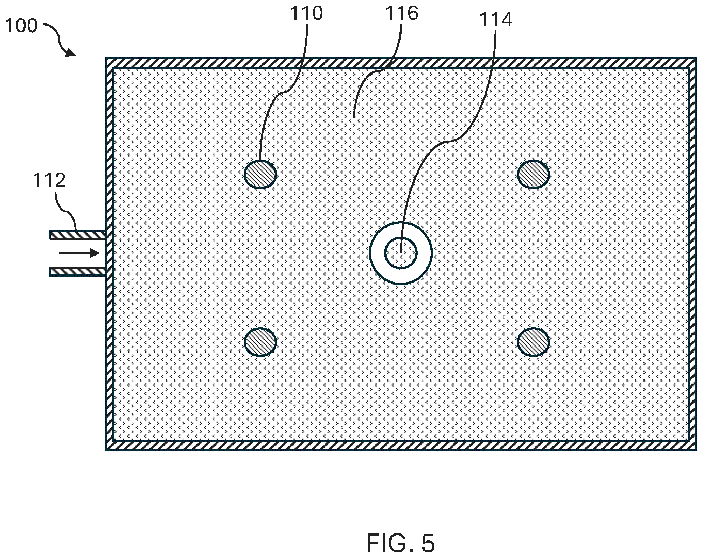

FIG. 5 illustrates a non-limiting example of the two-phase cold plate 100 to show the relative dispositions of the fluid inlet 112, fluid outlet 114, and plurality of structural posts 110. As shown, the structural posts 110 may be cylindrical to minimize resistance to fluid flow, and are positioned out of the flow path from the fluid inlet 112 and to the fluid outlet 114 such that the supply of two-phase fluid into the two-phase cold plate 100 is substantially unobstructed as is the flow of two-phase fluid out of the two-phase cold plate 100. In embodiments, the number of structural posts 110 and their relative positions may be dependent on one or more of the dimensions of the two-phase cold plate 100, distance between the bottom plate 104 and the top plate, diameter of the structural posts 110, thickness of the bottom plate 104, anticipated internal pressure, materials, etc. In embodiments, the structural posts 110 may be arranged to form rows and columns, for instance the two rows and two columns of substantially equidistant spaced structural posts 110 as shown. In embodiments, the disposition of one or more of the fluid inlet 112 and fluid outlet 114 may be determinative of the structural post 110 positions.

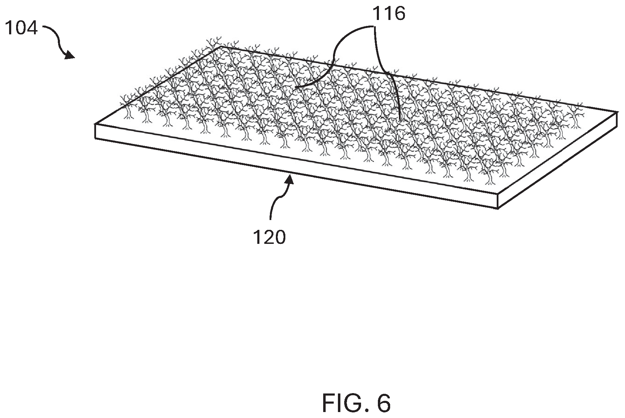

FIG. 6 illustrates a non-limiting example of a configuration of the bottom plate 104. As shown, the bottom plate 104 is rectangular and has a substantially planar 'bottom' surface 120 configured to be positioned in thermal contact with electronic equipment, and a 'top' surface including a plurality of thermally conductive structures 116 forming a boiling enhancement surface configured to be positioned in the fluid channel 118 in contact with the two-phase fluid to facilitate heat transfer. In embodiments, the plurality of thermally conductive structures 116 may be biomimetic structures configured to emulate structures in nature, for instance a forest of trees as shown. In embodiments, the thermally conductive structures 116 may be singular structures as shown positioned in spaced apart relation or may be connected structures forming a mesh. The number, spacing, height, pattern, shape, etc. of the thermally conductive structures 116 may vary and is not intended to be limiting as shown. Broadly, an object of the shape of the thermally conductive structures 116 is to maximize heat transfer minimizing flow resistance through the fluid channel 118.

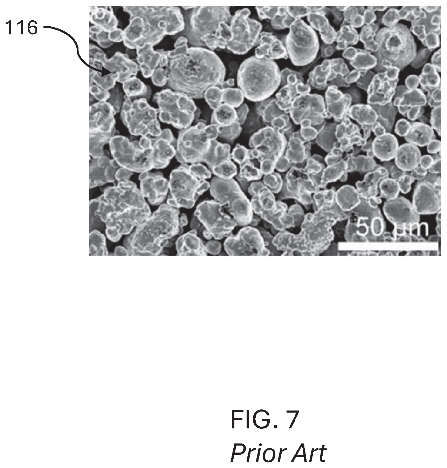

FIG. 7 illustrates a non-limiting example of prior art biomimetic structures suitable for use as thermally conductive structures 116 in the two-phase cold plate according to the present disclosure, wherein the biomimetic structures emulate nature, for instance trees or bushes to provide increased surface area for heat transfer. In embodiments, the plurality of thermally conductive structures 116 may be integrally formed with the bottom plate 104, for instance grown or built by an additive manufacturing process. In embodiments, each of the housing components, structural posts 110, and thermally conductive structures 116 may be made from conductive material, for instance copper. In embodiments, the bottom plate 104 including the thermally conductive structure 116 may be manufactured and subsequently attached to the respective sidewalls 108, structural posts 1110, and top plate 106. In another embodiment, the entire two-phase cold plate 100 may be built by an additive manufacturing process.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.
The disclosure comprises the following items:
1. A two-phase cold plate comprising:
   a housing including a base plate, a top plate, and sidewalls delimiting a fluid channel;
   a plurality of structural posts disposed in the fluid channel and extending between the base plate and the top plate, the plurality of structural posts configured to structurally support the housing and maintain a spacing between the base plate and the top plate;
   a fluid inlet fluidly coupled to the fluid channel, the fluid inlet configured to deliver a working fluid into the fluid channel;
   a fluid outlet fluidly coupled to the fluid channel, the fluid outlet configured to discharge the working fluid from the fluid channel; and
   a boiling enhancement surface formed on the base plate, the boiling enhancement surface including a plurality of thermally conductive structures extending from the base plate into the fluid channel, the plurality of thermally conductive structures configured to increase a heat transfer surface area within the fluid channel and to promote nucleate boiling of the working fluid within the fluid channel.
2. The two-phase cold plate according to item 1, wherein the plurality of thermally conductive structures are biomimetic structures that emulate a forest of trees.
3. The two-phase cold plate according to item 1 or item 2, wherein the plurality of thermally conductive structures are separate structures positioned in spaced apart relation.
4. The two-phase cold plate according to any preceding item, wherein the base plate and the plurality of thermally conductive structures are integrally formed.
5. The two-phase cold plate according to any preceding item, wherein the base plate and the plurality of thermally conductive structures comprise copper.
6. The two-phase cold plate according to any preceding item, wherein the fluid inlet is disposed through one of the sidewalls or through the top plate, and the fluid outlet is disposed through one of the sidewalls or through the top plate.
7. The two-phase cold plate according to any preceding item, wherein the base plate and the top plate are parallel, and the plurality of structural posts are orthogonal to the base plate and the top plate.
8. The two-phase cold plate according to any preceding item, wherein a thickness of the base plate is between 0.3 mm and 3.0 mm.
9. The two-phase cold plate according to any preceding item, wherein a height of the fluid channel is no more than 10.0 mm, and a height of each of the plurality of thermally conductive structures is no more than 4.0 mm.
10. The two-phase cold plate according to any preceding item, wherein a thickness of the base plate is less than a thickness of each of the top plate and the sidewalls.
11. A cooling system, comprising:
   a two-phase cold plate configured to be positioned in thermal contact with electronic equipment, the two-phase cold plate comprising:
      a housing including a base plate, a top plate, and sidewalls delimiting a fluid channel;
      a plurality of structural posts disposed in the fluid channel and extending between the base plate and the top plate;
      a fluid inlet fluidly coupled to the fluid channel;
      a fluid outlet fluidly coupled to the fluid channel; and
      the base plate having a boiling enhancement surface including a plurality of thermally conductive structures extending from the base plate into the fluid channel for providing increased surface area for heat transfer within the fluid channel; and
   a vaporizable working fluid configured to be pumped into the fluid channel.
12. The cooling system according to item 11, wherein the plurality of thermally conductive structures are biomimetic structures that emulate a forest of trees.
13. The cooling system according to item 11 or item 12, wherein the plurality of thermally conductive structures are separate structures positioned in spaced apart relation.
14. The cooling system according to any of items 11-13, wherein the base plate and the plurality of thermally conductive structures are integrally formed.
15. The cooling system according to any of items 11-14, wherein the base plate and the plurality of thermally conductive structures comprise copper.
16. The cooling system according to any of items 11-15, wherein the fluid inlet is disposed through one of the sidewalls or through the top plate, and the fluid outlet is disposed through one of the sidewalls or through the top plate.
17. The cooling system according to any of items 11-16, wherein a thickness of the base plate is between 0.3 mm and 3.0 mm.
18. The cooling system according to any of items 11-17, wherein a height of the fluid channel is no more than 10.0 mm.
19. The cooling system according to any of items 11-18, wherein a height of each of the plurality of thermally conductive structures is no more than 4.0 mm.
20. A two-phase cold plate comprising:
   a housing defining a fluid channel and including a base plate, a top plate, and sidewalls extending between the base plate and the top plate;
   a fluid inlet configured to deliver a working fluid into the fluid channel;
   a fluid outlet configured to discharge the working fluid from the fluid channel;
   a plurality of structural posts disposed within the fluid channel and extending between the base plate and the top plate, the plurality of structural posts being configured to structurally support the housing and maintain a spacing between the base plate and the top plate; and
   a boiling enhancement surface formed on the base plate, the boiling enhancement surface including a plurality of thermally conductive structures extending from the base plate into the fluid channel,
   wherein the plurality of thermally conductive structures are configured to increase a heat transfer surface area within the fluid channel and to promote nucleate boiling of the working fluid within the fluid channel,
   wherein the plurality of thermally conductive structures are configured to emulate a forest of trees and are arranged in spaced-apart relation to facilitate fluid flow between adjacent thermally conductive structures, and
   wherein the base plate is configured to be thermally coupled to an electronic heat source such that heat is conducted into the working fluid within the fluid channel to cause evaporation of the working fluid.

## Claims

1. A two-phase cold plate comprising:
a housing including a base plate, a top plate, and sidewalls delimiting a fluid channel;
a plurality of structural posts disposed in the fluid channel and extending between the base plate and the top plate, the plurality of structural posts configured to structurally support the housing and maintain a spacing between the base plate and the top plate;
a fluid inlet fluidly coupled to the fluid channel, the fluid inlet configured to deliver a working fluid into the fluid channel;
a fluid outlet fluidly coupled to the fluid channel, the fluid outlet configured to discharge the working fluid from the fluid channel; and
a boiling enhancement surface formed on the base plate, the boiling enhancement surface including a plurality of thermally conductive structures extending from the base plate into the fluid channel, the plurality of thermally conductive structures configured to increase a heat transfer surface area within the fluid channel and to promote nucleate boiling of the working fluid within the fluid channel.

2. The two-phase cold plate according to claim 1, wherein the plurality of thermally conductive structures are biomimetic structures that emulate a forest of trees.

3. The two-phase cold plate according to claim 1 or claim 2, wherein the plurality of thermally conductive structures are separate structures positioned in spaced apart relation.

4. The two-phase cold plate according to any preceding claim, wherein the base plate and the plurality of thermally conductive structures are integrally formed.

5. The two-phase cold plate according to any preceding claim, wherein the base plate and the plurality of thermally conductive structures comprise copper.

6. The two-phase cold plate according to any preceding claim, wherein the fluid inlet is disposed through one of the sidewalls or through the top plate, and the fluid outlet is disposed through one of the sidewalls or through the top plate.

7. The two-phase cold plate according to any preceding claim, wherein the base plate and the top plate are parallel, and the plurality of structural posts are orthogonal to the base plate and the top plate.

8. The two-phase cold plate according to any preceding claim, wherein a thickness of the base plate is between 0.3 mm and 3.0 mm.

9. The two-phase cold plate according to any preceding claim, wherein a height of the fluid channel is no more than 10.0 mm, and a height of each of the plurality of thermally conductive structures is no more than 4.0 mm.

10. The two-phase cold plate according to any preceding claim, wherein a thickness of the base plate is less than a thickness of each of the top plate and the sidewalls.

11. The two-phase cold plate according to any preceding claim, wherein the base plate is configured to be thermally coupled to an electronic heat source such that heat is conducted into the working fluid within the fluid channel to cause evaporation of the working fluid.

12. A cooling system, comprising:
the two-phase cold plate of any preceding claim and configured to be positioned in thermal contact with electronic equipment; and
a vaporizable working fluid configured to be pumped into the fluid channel of the two-phase cold plate.
